# EUROPEAN PATENT APPLICATION

(11) **EP 4 709 096 A1**
(43) Date of publication of application: **11.03.2026**
(21) Application number: 25184901.4
(22) Date of filing: 24.06.2025
(51) Int. Cl.: H10F 10/165, H10F 77/20, H10F 77/30, H10F 77/70

(54) **SOLAR CELL AND MANUFACTURING METHOD**

(30) Priority: 05.09.2024 CN 202411238855
(71) Applicant: Longi Green Energy Technology Co., Ltd., Xi'an, Shaanxi 710100 (CN)
(72) Inventor: Zhang, Ze, Xi'an, Shaanxi, 710100 (CN); Chen, Lin, Xi'an, Shaanxi, 710100 (CN); Ma, Qiangsheng, Xi'an, Shaanxi, 710100 (CN); Sun, Chang, Xi'an, Shaanxi, 710100 (CN); Hong, Chengjian, Xi'an, Shaanxi, 710100 (CN); Qu, Minghao, Xi'an, Shaanxi, 710100 (CN)
(74) Representative: Grünecker Patent- und Rechtsanwälte PartG mbB

(57) **Abstract**

The present application relates to the field of semiconductor device technologies, and provides a solar cell and a manufacturing method. The solar cell in the present application includes: a semiconductor substrate, including a first surface provided with a plurality of first texture structures, where each of the first texture structures includes a side surface and a top surface in a direction away from the first surface, and the top surface is connected to one end of the side surface; a tunneling layer, located on the first surface of the semiconductor substrate; a doped semiconductor layer, located on a surface of the tunneling layer away from the semiconductor substrate; an electrode, located on a surface of the doped semiconductor layer away from the semiconductor substrate, and in contact with the doped semiconductor layer; and metal crystals, distributed at a position in the doped semiconductor layer that is in contact with the electrode, where a distribution density of the metal crystals in the doped semiconductor layer located on the top surface is greater than a distribution density of the metal crystals in the doped semiconductor layer located on the side surface.

## Description

### TECHNICAL FIELD

The present application relates to the field of photovoltaic solar cell technologies, and specifically to a solar cell and a manufacturing method.

### BACKGROUND

Different passivated contact solutions are more and more applied to solar cells to improve efficiency. A back surface of a tunnel oxide passivated contact (TOPCon) solar cell usually has a polished structure. To increase a light trapping capability of the back surface of the TOPCon solar cell, the polished structure on the back surface of the solar cell usually has concave-convex microstructures.

In conventional microstructures, during the deposition of a tunneling layer and a doped polycrystalline silicon layer, the tunneling layer and the doped polycrystalline silicon layer are usually thin on side walls of the concave-convex microstructures and are unevenly distributed. During subsequent sintering, the side walls of the concave-convex microstructures has a burn-through risk.

### SUMMARY

In view of this, to at least partially resolve at least one of the technical problems mentioned above, the present application provides a solar cell and a manufacturing method.

To achieve the foregoing objective, the technical solutions adopted in the present application are as follows:
According to an aspect of the present application, a solar cell is provided, including: a semiconductor substrate, including a first surface provided with a plurality of first texture structures, where each of the first texture structures includes a side surface and a top surface in a direction away from the first surface, and the top surface is connected to one end of the side surface; a tunneling layer, located on the first surface of the semiconductor substrate; a doped semiconductor layer, located on a surface of the tunneling layer away from the semiconductor substrate; an electrode, located on a surface of the doped semiconductor layer away from the semiconductor substrate, and in contact with the doped semiconductor layer; and metal crystals, distributed at a position in the doped semiconductor layer that is in contact with the electrode, where a distribution density of the metal crystals in the doped semiconductor layer located on the top surface is greater than a distribution density of the metal crystals in the doped semiconductor layer located on the side surface.

According to another aspect of the present application, a manufacturing method for the foregoing solar cell is provided, including: texturing and polishing a first surface of an initial substrate to form a plurality of first texture structures on the first surface to obtain a semiconductor substrate; sequentially manufacturing a tunneling layer, a doped semiconductor layer, a first passivation anti-reflection layer, and an electrode material on the first surface of the semiconductor substrate; and sintering the electrode material to form an electrode, making the electrode in contact with the doped semiconductor layer through the first passivation anti-reflection layer, and forming metal crystals at a position in the doped semiconductor layer that is in contact with the electrode.

The first texture structure of the solar cell provided in the present application helps increase scattering and absorption of sunlight, thereby improving a light trapping effect. Because the top surface is formed in the first texture structure, a proportion of the side surface is small, so that a probability that the side surface is in contact with a metal slurry can be reduced, and metal crystals are less likely to form on the side surface, thereby helping reduce a burn-through risk. An electrode slurry is easy to sinter to form a porous morphology, so that a probability that the side surface is in contact with the metal slurry is further reduced, thereby reducing burn-throughs at side walls and suppressing the formation of metal crystals. In this way, a special distribution morphology that the distribution density of the metal crystals on the top surface is greater than the distribution density of the metal crystals on the side surface is formed. This helps to optimize a current collection path and facilitates carrier extraction in a direction perpendicular to the top surface, thereby improving the photoelectric conversion performance of the solar cell.

In the present application, the texturing of the first surface of the initial substrate facilitates the formation of fine texture or roughness on the first surface of the initial substrate, thereby increasing scattering and absorption of light. Based on the polishing of the first surface, the first texture structure having the top surface is formed, so that the proportion of the side surface is reduced. Next, the tunneling layer, the doped semiconductor layer, the first passivation anti-reflection layer, and the electrode are sequentially manufactured on the first surface. It is found that based on the foregoing microstructures having small proportions of side surfaces, the doped semiconductor layer on the side surfaces is less likely to be in contact with the electrode, and metal crystals are less likely to form on the side surface, thereby reducing a burn-through risk, and the distribution morphology that the distribution density of the metal crystals located on the top surface is greater than the distribution density of the metal crystals located on the side surface is formed.

### BRIEF DESCRIPTION OF THE DRAWINGS

The foregoing and other objectives, features, and advantages of the present application will become more apparent through the following description of embodiments of embodiments of the present application with reference to the accompanying drawings, in which:
FIG. 1 is a schematic diagram of a structure of a solar cell according to an embodiment of the present application;
FIG. 2 is a schematic side view of a first texture structure according to an embodiment of the present application, where a is a schematic side view of the first texture structure being a protrusion structure, and b is a schematic side view of the first texture structure being a concave structure;
FIG. 3 is a scanning electron micrograph of a cross-section of a solar cell according to an embodiment of the present application;
FIG. 4 is a scanning electron micrograph of a cross-section of a first texture structure according to an embodiment of the present application;
FIG. 5 is a schematic side view of a protrusion structure of a first texture structure according to an embodiment of the present application;
FIG. 6A to FIG. 6C are respectively partial enlarged views of distribution of metal crystals at different positions of a cross-section of a solar cell;
FIG. 7 is a schematic flowchart of a manufacturing method for a solar cell according to another embodiment of the present application;
FIG. 8 is a schematic flowchart of a manufacturing method for a TOPCon solar cell according to yet another embodiment of the present application;
FIG. 9 is a schematic diagram of a manufacturing process procedure of a TOPCon solar cell according to yet another embodiment of the present application; and
FIG. 10 is a schematic diagram of a structure of a back contact solar cell according to still another embodiment of the present application.

### DETAILED DESCRIPTION

To make the objectives, technical solutions, and advantages of the present application more comprehensible, the present application is further described below in detail with reference to specific embodiments and the accompanying drawings.

The terms used herein are intended only to describe specific embodiments and are not intended to limit the present application. The terms "comprise", "include", and the like used herein indicate the presence of features, steps, operations, and/or components, but do not preclude the presence or addition of one or more other features, steps, operations, or components. All terms (including technical and scientific terms) used herein have the ordinary meanings as understood by a person of skilled in the art, unless defined otherwise. It should be noted that the terms used herein should be interpreted as having meanings consistent with the context of this specification and should not be interpreted in an idealized or excessively stereotyped manner.

A relative position of two members (for example, film layers or regions) mentioned in the present application, for example, "on", or "above", may mean that the two members are in direct contact, or may mean that the two members are not in direct contact. Similarly, a relative position of two members mentioned in the present application, for example, "under", or "below", may mean that the two members are in direct contact, or may mean that the two members are not in direct contact. For example, when a member (for example, a film layer or region) is referred to as being "on another member", the member may be directly on the another member, or another member may exist between the two. In another aspect, when a member is referred to as being "directly on another member", no member exists between the two. In addition, when a member is referred to as being "on another member", the members have an upper-lower relationship in a top-view direction, and the member may be above or below the another member. Therefore, the upper-lower relationship depends on the orientation of an apparatus.

For a solar cell including a tunnel passivated contact structure, to improve a surface light trapping capability, concave-convex structures are usually manufactured on a surface of a semiconductor substrate. However, during subsequent deposition of a tunneling layer and a doped polycrystalline silicon layer on the concave-convex structures, the tunneling layer and the doped polycrystalline silicon layer are usually thin on side walls of the concave-convex structures, and formed layered structures are not uniform. During a subsequent metal process, for example, sintering of an electrode, positions of the side walls of the concave-convex structures are relatively prone to a burn-through risk, especially in a case of a laser-induced sintering process. Because an instantaneous large current density exists in the process, the burn-through risk caused by nonuniformity of the tunneling layer and the doped polycrystalline silicon layer on the side walls is further increased.

It is found in a process of implementing the idea of the present application that a first surface of an initial substrate is textured and polished to form first texture structures having top surfaces on the first surface of the semiconductor substrate, which helps reduce a proportion of a side surface, so that a probability that the side surface is in contact with a metal slurry is reduced, and metal crystals are less likely to form on the side surface, thereby reducing a burn-through risk of the side surface. In addition, during manufacturing of an electrode using an electrode slurry, a porous morphology is formed, which further reduces a probability that the side surface is in contact with the electrode slurry, and is more beneficial to reducing the burn-through risk of the side surface, thereby suppressing the formation of metal crystals on the side surface. In this way, more metal crystals are distributed on the top surface, thereby helping optimize a current collection path.

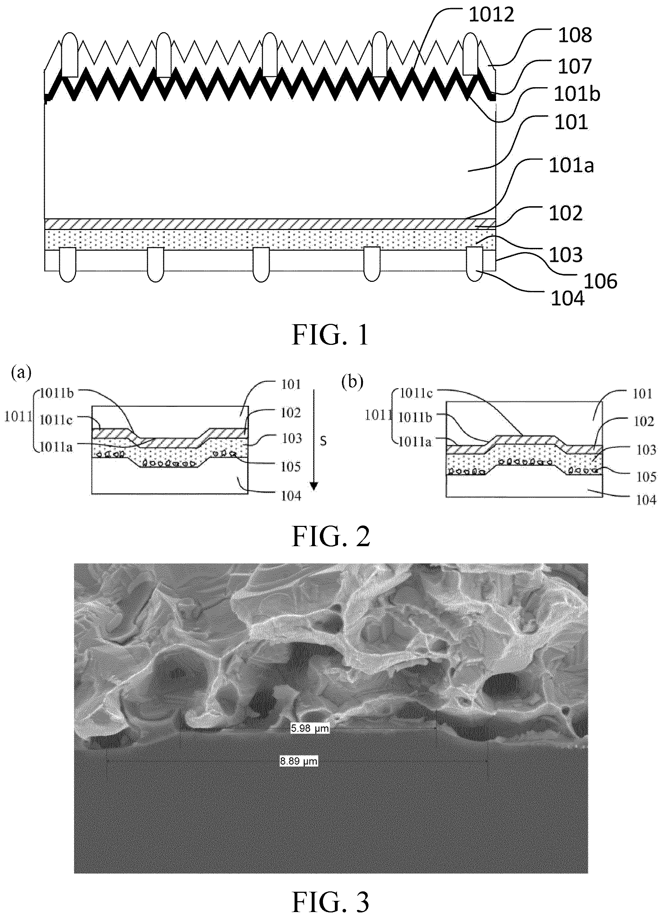

Specifically, according to an embodiment of an aspect of the present application, a solar cell is provided. FIG. 1 is a schematic diagram of a structure of a solar cell according to an embodiment of the present application. FIG. 2 is a schematic side view of a first texture structure according to an embodiment of the present application, where (a) is a schematic side view of the first texture structure being a protrusion structure, and (b) is a schematic side view of the first texture structure being a concave structure. As shown in FIG. 1 and (a) and (b) in FIG. 2, the solar cell provided in the embodiments of the present application includes a semiconductor substrate 101, a tunneling layer 102, a doped semiconductor layer 103, an electrode 104, and metal crystals 105. The semiconductor substrate 101 includes a first surface 101a provided with a plurality of first texture structures 1011. Each of the first texture structures 1011 includes a side surface 1011b and a top surface 1011a in a direction away from the first surface 101a. The top surface 1011a is connected to one end of the side surface 1011b. The tunneling layer 102 is located on the first surface 101a of the semiconductor substrate 101. The doped semiconductor layer 103 is located on a surface of the tunneling layer 102 away from the semiconductor substrate 101. The electrode 104 is located on a surface of the doped semiconductor layer 103 away from the semiconductor substrate 101 and in contact with the doped semiconductor layer 103. The metal crystals 105 are distributed at a position in the doped semiconductor layer 103 that is in contact with the electrode 104. At least some elements of the metal crystals 105 are from elements in the electrode 104. A distribution density of the metal crystals 105 in the doped semiconductor layer located on the top surface 1011a is greater than a distribution density of the metal crystals 105 in the doped semiconductor layer located on the side surface 1011b. The foregoing relationship of the distribution densities may be understood as that the distribution density in the doped semiconductor layer on the top surface 1011a is greater than the distribution density in the doped semiconductor layer on the side surface 1011b adjacent to the top surface 1011a. Alternatively, the relationship may be understood as that within a range of the first texture structures covered by the entire doped semiconductor layer 103, an overall distribution density in the doped semiconductor layer on the top surface 1011a is greater than an overall distribution density in the doped semiconductor layer on the side surface 1011b adjacent to the top surface 1011a. Alternatively, the relationship may be understood as that within a range of the first texture structures in a local region covered by the entire doped semiconductor layer 103, an overall distribution density in the doped semiconductor layer on the top surface 1011a is greater than an overall distribution density in the doped semiconductor layer on the side surface 1011b adjacent to the top surface 1011a.

According to the embodiments of the present application, referring to (a) and (b) in FIG. 2, in a direction S away from the first surface, the first texture structure may be a protrusion structure or a concave structure, and the top surface 1011a of the first texture structure is a plane projecting in a direction away from the semiconductor substrate 101.

Further, in some embodiments, the "first texture structures" on the semiconductor substrate 101 may be microstructures obtained by texturing and polishing the first surface of an initial substrate. It may be understood that the top surface 1011a is a polished surface formed by polishing.

According to the embodiments of the present application, the "distribution density" of the metal crystals 105 is a quantity of metal crystals in a same unit volume or unit top view area or unit cross-sectional area of the metal crystals 105 in the doped semiconductor layer on the top surface 1011a and the side surface 1011b.

According to the embodiments of the present application, the semiconductor substrate 101 may be an N-type or a P-type silicon substrate, for example, may be made of one semiconductor material of monocrystalline silicon, polycrystalline silicon, and microcrystalline silicon, and is an N-type or a P-type monocrystalline silicon substrate in some embodiments. The conversion efficiency of a solar cell based on a monocrystalline silicon substrate is higher than that of another type, for example, a polycrystalline silicon solar cell. A donor impurity, for example, an element of phosphorus (P), arsenic (As), or antimony (Sb), is introduced into these semiconductor materials to obtain an N-type silicon substrate, or an acceptor impurity, for example, an element of boron (B), aluminum (Al), or gallium (Ga), is introduced into these semiconductor materials to obtain a P-type silicon substrate.

Further, in some embodiments, the semiconductor substrate 101 may be an N-type monocrystalline silicon substrate of a (100) crystallographic direction. The top surface 1011a is a (100) crystallographic plane, and an electronic mobility on the top surface 1011a is higher than that when the side surface 1011b is another crystallographic plane. Such setting of the distribution densities of the metal crystals on the top surface 1011a and the side surface 1011b better facilitates the efficient transport of electrons, and makes it easy to extract photogenerated carriers, thereby helping form better device performance.

According to the embodiments of the present application, the tunneling layer 102 and the doped semiconductor layer 103 cooperate to form a tunnel passivated contact structure. The tunneling layer 102 is used for transporting majority carriers and achieving a passivation effect, and may be made of, but not limited to, silicon oxide, gallium oxide, aluminum oxide, titanium oxide, or another material. A thickness of the tunneling layer 102 may range from 1 to 2 nm, and may be, for example, 1 nm, 1.2 nm, 1.5 nm, 1.8 nm, or 2 nm in some embodiments.

The doped semiconductor layer 103 may be made of at least one semiconductor material of a polycrystalline silicon layer, a microcrystalline silicon layer, and the like, and a doping type of the doped semiconductor layer 103 may be the same as or different from that of the semiconductor substrate 101, and may be specifically determined based on a solar cell type and the semiconductor substrate 101. For example, a TOPCon solar cell is used as an example. In a case that the semiconductor substrate 101 is an N-type silicon substrate, the doped semiconductor layer 103 may be N-type doped or P-type doped, or in a case that the semiconductor substrate 101 is a P-type silicon substrate, the doped semiconductor layer 103 may be N-type doped or P-type doped. For example, a thickness of the doped semiconductor layer 103 may range from 80 to 200 nm, and may be, for example, 80 nm, 100 nm, 120 nm, 150 nm, 180 nm, or 200 nm.

According to the embodiments of the present application, the first texture structure 1011 is formed so that concave-convex texture structures are provided on a surface of the semiconductor substrate 101, thereby helping increase a light trapping effect and improve the photoelectric conversion efficiency of the solar cell. The first texture structure 1011 having the top surface 1011a has a side surface accounting for a small proportion, which reduces a probability that the doped semiconductor layer on the side surface is in contact with a metal slurry, so that during subsequent sintering, metal crystals are less likely to form on the side surface 1011b, and a probability that the side surface 1011b is burned through is also reduced.

Further, for an electrode slurry, a proper composition of the slurry is selected, and a porous morphology is formed after sintering. Porous structures are more easily formed on the side surface 1011b of the first texture structure 1011. The presence of the porous structures further reduces a probability that the side surface is in contact with the metal slurry, further reduces a probability that the side surface 1011b is burned through, and also suppresses formation of metal crystals on the side surface 1011b. Therefore, the distribution density of the metal crystals on the top surface 1011a is greater than the distribution density of the metal crystals on the side surface 1011b, which facilitates the extraction of photogenerated carriers in a direction perpendicular to the top surface 1011a, so that the photoelectric conversion efficiency and the current collection efficiency of the solar cell are improved, thereby helping obtain better device performance.

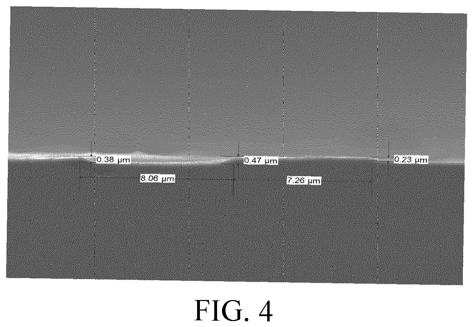

FIG. 3 is a scanning electron micrograph of a partial cross-section of a solar cell according to an embodiment of the present application. FIG. 4 is a scanning electron micrograph of a cross-section of a first texture structure according to an embodiment of the present application. The first texture structure 1011 is a protrusion structure, and for example, may have a prismatic frustum shape shown in FIG. 3 or FIG. 4, but is not limited thereto, and may have a conical frustum shape. The "prismatic frustum shape" means approximately a shape of a prismatic frustum, and it is also the same with the "conical frustum shape". The prismatic frustum shape may further be, for example, pyramid pedestal structures stacked in a staggered manner. An appropriate protrusion structure facilitates uniform deposition of a subsequent tunnel oxide layer and doped polycrystalline silicon layer, and also makes the side surface 1011b account for a low proportion in a case of a same tilt angle of the side surface. The "tilt angle" indicates an included angle between a plane in which two ends of the side surface 1011b are located and the top surface.

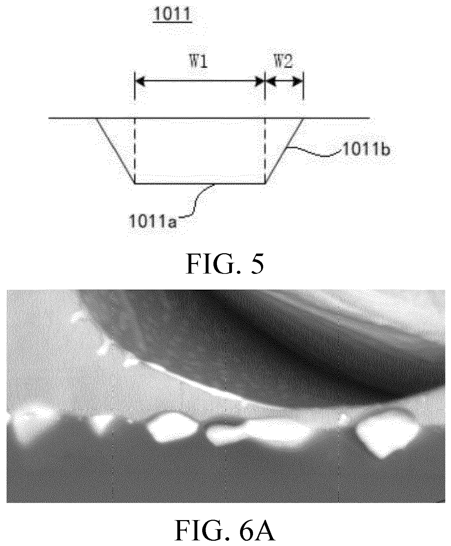

According to the embodiments of the present application, FIG. 5 is a schematic side view of a protrusion structure of a first texture structure according to an embodiment of the present application. As shown in FIG. 5, in a direction away from the first surface, the first texture structure 1011 includes the side surface 1011b and the top surface 1011a. A ratio of a lateral dimension W2 of an orthographic projection of the side surface 1011b on a plane in which the top surface 1011a is located to a lateral dimension W1 of the top surface 1011a ranges from 0.1 to 0.3, and may be, for example, 0.1, 0.13, 0.15, 0.18, 0.2, 0.23, 0.25, 0.27, or 0.3. As the ratio of the two increases, a staggered and fluctuating morphology formed by a plurality of pedestal structures is clearer. However, if the ratio is excessively high, the side surface 1011b occupies a large proportion, which is not beneficial to uniform deposition of subsequent functional layers such as a tunnel oxide layer and a doped polycrystalline silicon layer that are manufactured on the first surface 101a. More importantly, a burn-through risk of the side surface 1011b is increased. If the ratio is excessively low, it is difficult for the subsequent functional layers to maintain the microscale morphology defined by the plurality of protrusion structures, and it is difficult for the light incident rate and the light utilization to be effectively improved. It may be understood that, the "lateral dimension" of the top surface 1011a may be a dimension in the plane in which the top surface 1011a is located. For example, when the top surface 1011a is rectangular, the lateral dimension of the top surface 1011a may be a side length or the length of a diagonal, and when the top surface 1011a is circular, the lateral dimension of the top surface 1011a may be the length of a diameter.

Further, the lateral dimension W2 of the orthographic projection of the side surface 1011b on the plane in which the top surface 1011a is located ranges from 0.3 to 3 µm, and may be, for example, 0.3 µm, 0.5 µm, 0.8 µm, 1 µm, 1.5 µm, 2 µm, 2.5 µm, or 3 µm. The lateral dimension W1 of the top surface 1011a ranges from 5 to 25 µm, and may be, for example, 5 µm, 7 µm, 9 µm, 11 µm, 13 µm, 15 µm, 17 µm, 19 µm, 21 µm, or 23 µm. A proper dimension of the protrusion structures helps reduce a probability that the side surface 1011b is in contact with a metal slurry, and ensures that the first texture structure 1011 has a good light trapping effect.

According to the embodiments of the present application, referring to FIG. 2, the first texture structure 1011 further includes a bottom surface 1011c, connected to the other end of the side surface 1011b away from the top surface 1011a, and located between the side surfaces 1011b of two adjacent first texture structures 1011. A distribution density of the metal crystals 105 in the doped semiconductor layer located on the bottom surface 1011c is greater than the distribution density of the metal crystals 105 in the doped semiconductor layer located on the side surface. Because the top surface 1011a and the bottom surface 1011c are formed in the first texture structure 1011, the proportion of the side surface 1011b is further reduced, so that the probability that the side surface 1011b is in contact with the metal slurry is further reduced, and metal crystals are less likely to form on the side surface 1011b, thereby reducing a burn-through risk of the side surface 1011b. In addition, a large quantity of metal crystals can be formed in the doped semiconductor layer on the bottom surface 1011c, thereby further optimizing a current collection path and helping reduce contact resistance.

In a case that the semiconductor substrate is an N-type monocrystalline silicon substrate having a (100) crystallographic direction, the bottom surface 1011c is also a (100) crystallographic plane. Similar to the top surface 1011a, the distribution of the metal crystals 105 on the bottom surface 1011c is more beneficial to efficient transport of electrons and extraction of photogenerated carriers, thereby achieving better device performance.

According to the embodiments of the present application, a distance between two adjacent first texture structures 1011 is less than or equal to 9 µm, and may be, for example, 0 µm, 1 µm, 2 µm, 3 µm, 4 µm, 5 µm, 6 µm, 7 µm, 8 µm, or 9 µm.

When two adjacent first texture structures are both protrusion structures, the distance between two adjacent first texture structures 1011 is the shortest distance between two adjacent side surfaces 1011b of the two adjacent protrusion structures. When two adjacent first texture structures are both concave structures, the distance between two adjacent first texture structures 1011 is the shortest distance between two adjacent side surfaces 1011b of the two adjacent concave structures.

When the distance between two adjacent first texture structures 1011 is 0, the pyramid pedestal structures stacked in a staggered manner. As the distance increases, a quantity of the first texture structures 1011 per unit area is smaller. The distance between the first texture structures 1011 is maintained within the foregoing suitable range, which helps maintain the microscale morphology defined by the plurality of first texture structures 1011 to improve scattering and reflection capabilities of incident light, thereby improving the light utilization. In addition, the proportion of the side surface 1011b can be reduced, thereby reducing a probability that the side surface 1011b is in contact with the metal slurry.

According to the embodiments of the present application, the height from the bottom surface 1011c to the top surface 1011a ranges from 0.1 to 0.8 µm, and may be, for example, 0.1 µm, 0.2 µm, 0.3 µm, 0.4 µm, 0.5 µm, 0.6 µm, 0.7 µm, or 0.8 µm. A suitable height facilitates uniform deposition of subsequent functional layers such as a tunnel oxide layer and a doped polycrystalline silicon layer on the first surface 101a.

According to the embodiments of the present application, referring to FIG. 3 and FIG. 4 again, the side surface 1011b of the first texture structure 1011 has a curvature recessed toward an interior of the semiconductor substrate 101. In this way, the recessed bottom of the first texture structure 1011 presents a recessed curved surface. The morphology of the recessed curved surface helps reduce a probability that the side surface 1011b is in contact with the metal slurry, thereby helping prevent the doped semiconductor layer 103 located on the side surface 1011b from being burned through.

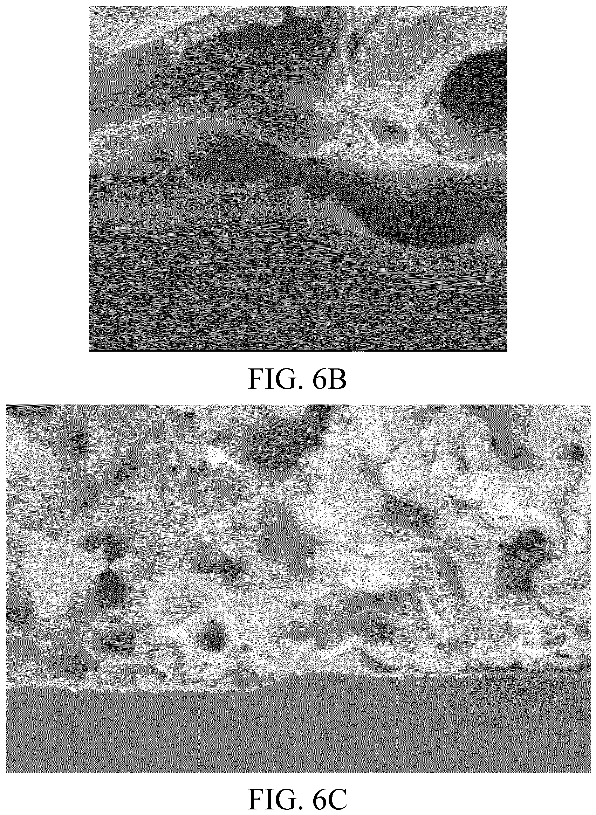

According to the embodiments of the present application, FIG. 6A to FIG.6C are respectively partial enlarged views of distribution of metal crystals at different positions of a cross-section of a solar cell. As shown in FIG. 6A to FIG. 6C, the metal crystals are mainly dispersedly distributed in the doped semiconductor layer 103. Further, the metal crystals 105 are dendritic, tooth-like, or flower-like nanoparticles and an agglomerate of metal particles. An average particle size of the metal crystals 105 ranges from 20 to 200 nm, and may be, for example, 20 nm, 40 nm, 60 nm, 100 nm, 140 nm, 180 nm, or 200 nm. The formation of the metal crystals 105 is beneficial to collection and transport of photogenerated carriers generated by photoexcitation. The dimension and the morphology of the metal crystals 105 may be regulated through a sintering process of the electrode 104, for example, a heating sintering and/or laser-enhanced contact optimization process. A suitable particle size and morphology of the metal crystals 105 help regulate the transport of the photogenerated carriers.

According to the embodiments of the present application, the metal crystals 105 may be an alloy including a metal element of the electrode 104 and a silicon element. The alloy can establish a good ohmic contact between the electrode and the silicon substrate, which helps improve the transport efficiency of photogenerated carriers and lower the contact resistance.

According to the embodiments of the present application, further as shown in FIG. 1, the semiconductor substrate 101 further includes a second surface 101b provided with a plurality of second texture structures 1012, and each of the second texture structures 1012 is a concave structure or a protrusion structure. The formed second texture structures help improve a light trapping effect and increase light absorption, thereby improving photoelectric conversion efficiency. The solar cell further includes an emitter 107, formed in the second surface of the semiconductor substrate 101.

According to the embodiments of the present application, further, in some embodiments, the emitter 107 usually has a high doping concentration to form a good ohmic contact and lower the contact resistance, thereby improving current injection efficiency. The emitter 107 may be N-type doped or P-type doped. A doping type of the emitter 107 may be the same as or different from that of the semiconductor substrate. Further, in some embodiments, for N-type doping, a donor element, for example, phosphorus (P), arsenic (As), or antimony (Sb), of a high concentration may be doped into the second surface 101b of the semiconductor substrate 101, or an acceptor element, for example, boron (B), aluminum (Al), or gallium (Ga), may be introduced into the second surface 101b of the semiconductor substrate 101.

According to the embodiments of the present application, further as shown in FIG. 1, the solar cell further includes a second passivation anti-reflection layer 108 located on a surface of the emitter 107. The second passivation anti-reflection layer 108 helps achieve good passivation anti-reflection, and improves a dark saturation current density and an implicit open circuit voltage of the solar cell. The second passivation anti-reflection layers 108 may be, for example, a stacked film of silicon dioxide, silicon nitride, or a combination thereof.

For example, each of the first passivation anti-reflection layer 106 and the second passivation anti-reflection layer 108 may include an aluminum oxide layer and a silicon nitride layer that are sequentially disposed in the direction away from the semiconductor substrate 101. Further, in some embodiments, a thickness of the aluminum oxide layer may range from 3 to 5 nm, and may be, for example, 3, 3.5, 4, 4.5, or 5 nm. A thickness of the silicon nitride layer may range from 80 to 120 nm, and may be, for example, 80, 90, 100, 110, or 120 nm.

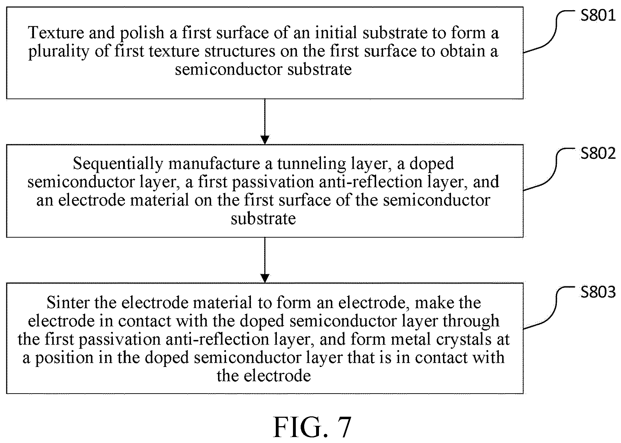

According to embodiments of another aspect of the present application, a manufacturing method for a solar cell is further provided. FIG. 7 is a schematic flowchart of a manufacturing method for a solar cell according to another embodiment of the present application. As shown in FIG. 7, with reference to FIG. 1, the manufacturing method for a solar cell in this embodiment of the present application includes operation S801 to operation S803.

Operation S801: Texture and polish a first surface of an initial substrate to form a plurality of first texture structures 1011 on the first surface 101a to obtain a semiconductor substrate 101.

Operation S802: Sequentially manufacture a tunneling layer 102, a doped semiconductor layer 103, a first passivation anti-reflection layer 106, and an electrode material on the first surface 101a of the semiconductor substrate 101.

Operation S803: Sinter the electrode material to form an electrode 104, make the electrode 104 in contact with the doped semiconductor layer 103 through the first passivation anti-reflection layer 106, and form metal crystals 105 at a position in the doped semiconductor layer 103 that is in contact with the electrode 104.

According to the embodiments of the present application, the plurality of first texture structures 1011 having top surfaces 1011a are formed based on the texturing and polishing of the first surface of the initial substrate. Each of the top surfaces 1011a is disposed so that each of the first texture structures 1011 has a side surface accounting for a small proportion. Therefore, during subsequent sintering, a probability that the doped semiconductor layer 103 located on a side surface 1011b is in contact with a metal slurry or a metal composition is reduced, and metal crystals are less likely to form in the doped semiconductor layer 103 on the side surface 1011b, thereby reducing the probability that the doped semiconductor layer 103 on the side surface 1011b is burned through. Therefore, a distribution density of the formed metal crystals 105 on the top surface 1011a of the first texture structures 1011 is greater than a distribution density of the metal crystals 105 on the side surface 1011b, thereby facilitating photogenerated carrier extraction in a direction perpendicular to the top surface 1011 a, and improving photoelectric conversion efficiency and current collection efficiency after a solar cell is manufactured.

According to the embodiments of the present application, operation S801 specifically includes: performing wet texturing on the first surface of the initial substrate, to form a plurality of second texture structures on the first surface; and polishing the wet-textured first surface using a polishing agent containing nitric acid and hydrofluoric acid, to form the plurality of first texture structures on the first surface, to obtain the semiconductor substrate 101.

According to the embodiments of the present application, further, in some embodiments, for example, the wet texturing may be performed to corrode the surface of the initial substrate, for example, a bare silicon wafer, using an alkaline solution (for example, containing 2 wt% to 6 wt% of potassium hydroxide or sodium hydroxide solution and 0.1 wt% to 1.0 wt% of a texturing additive) under a condition of 70 to 80°C. The wet texturing process is suitable for texturing a monocrystalline silicon wafer, to form a pyramid structure. For another example, the wet texturing may alternatively be performed using an organic solution (for example, an HF:HNO₃ solution with a volume ratio ranging from 5:1 to 1:6), the surface of the initial substrate is corroded under a condition of 5 to 45°C. The wet texturing process is suitable for texturing a polycrystalline silicon wafer, to form a pit structure. Certainly, the process is not limited to wet texturing. In addition, a dry texturing process, for example, laser etching, may be combined to form a uniformly arranged micropore array in the surface of the initial substrate. The dry texturing process is suitable for texturing a monocrystalline silicon wafer or a polycrystalline silicon wafer.

According to the embodiments of the present application, further, in some embodiments, a concentration of HNO₃ in the polishing agent is 68 wt%, and a concentration of HF is 0.2 wt%. The proper chemical polishing agent is selected, so that in the first texture structures 1011, the concentration of HF at the other end of the side surface 1011b away from the top surface is low, and it is difficult for an etching product to diffuse out from the other end. As a result, an etching rate close to the other end of the side surface 1011b has a gradient decreasing trend. Therefore, the side surface tends to be more rounded close to the other end, and an arc surface may even form a concaved curved surface, to reduce a contact between the side surface 1011b and the metal slurry, thereby reducing a burn-through risk of the side surface 1011b.

According to the embodiments of the present application, in operation S802, the tunneling layer 102 may be deposited on the surface of the semiconductor substrate 101 through chemical vapor deposition or atomic layer deposition as required. For example, an example in which the semiconductor substrate is a silicon substrate is used. The silicon substrate may be thermally oxidized using a low-pressure chemical vapor deposition, to obtain the tunneling layer 102 having a thickness ranging from 1 to 2 nm.

Further, in some embodiments, an undoped semiconductor layer may be deposited on a surface of the tunneling layer 102 through chemical vapor deposition; and then the doped semiconductor layer 103 is formed through diffusion or ion implantation as required. For example, the doped semiconductor layer 103 is a doped polycrystalline silicon layer. A polycrystalline silicon layer or an amorphous silicon layer may be deposited on the surface of the tunneling layer 102 through low-pressure chemical vapor deposition; and then the polycrystalline silicon layer or the amorphous silicon layer is transformed into a doped polycrystalline silicon layer using a diffusion process.

Further, in some embodiments, the first passivation anti-reflection layer 106 is deposited on the doped semiconductor layer 103, and the first passivation anti-reflection layer 106 may be, for example, at least one of silicon nitride and silicon dioxide.

Further, in some embodiments, the electrode material is printed on the first passivation anti-reflection layer 106. The printing method may be, for example, screen printing, ink-jet printing, and the like, and is specifically used as required. Because an electrode slurry, for example, a silver slurry, used in printing contains an organic component and is prone to volatilization in a subsequent sintering process, a porous morphology shown in FIG. 3 is formed.

According to the embodiments of the present application, operation S803 may be performed in a manner of thermal sintering or laser-assisted sintering, where the laser-assisted sintering is preferred, and specifically includes: undersintering the electrode material using a thermal process; and irradiating an edge region of the undersintered electrode material that is in contact with the doped semiconductor layer 103 with a laser. It may be understood that, "undersintering" in the present application is making the electrode in an incompletely sintered state by lowering a sintering temperature and/or shortening a sintering time in a sintering process, for example, to avoid excessive interdiffusion caused by excessive sintering. After undersintering, an edge of the electrode material that is in contact with the doped semiconductor layer 103 is irradiated with a laser, to induce interdiffusion between a metal composition of the electrode 104 and a silicon composition of the doped semiconductor layer 103, thereby helping form the metal crystals 105. Laser induction helps form a good ohmic contact between the electrode 104 and the doped semiconductor layer 103, thereby helping improve carrier transportation.

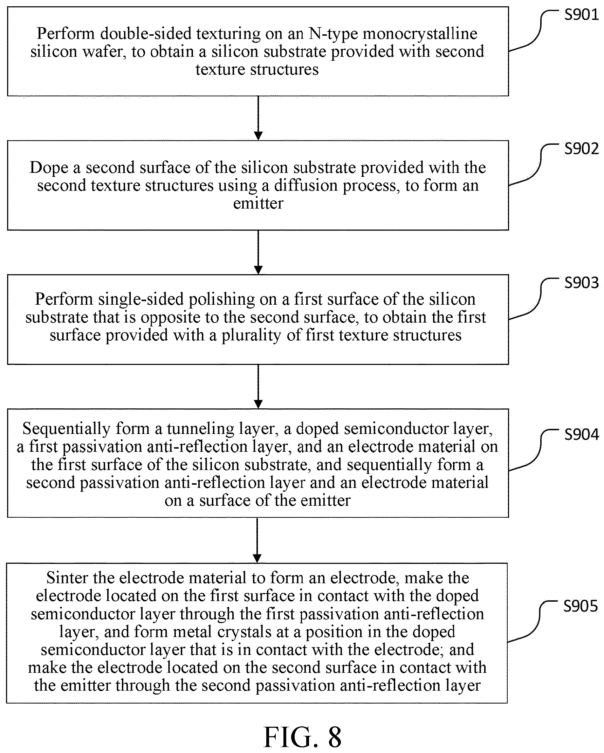

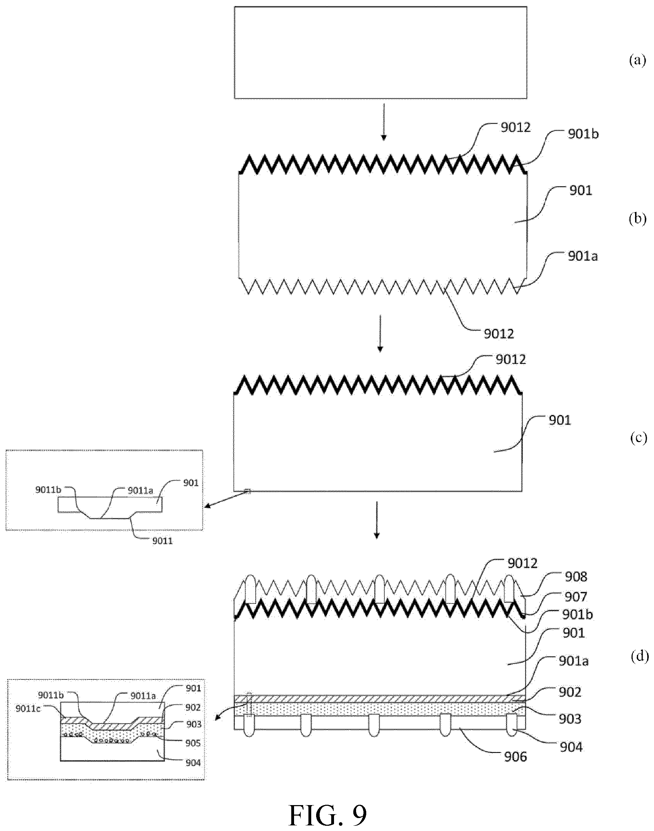

Specifically, a TOPCon solar cell is used as an example. FIG. 8 is a schematic flowchart of a manufacturing method for a TOPCon solar cell according to yet another embodiment of the present application. FIG. 9 is a schematic diagram of a manufacturing process procedure of a TOPCon solar cell according to yet another embodiment of the present application. As shown in FIG. 9 and FIG. 9, the manufacturing method for a TOPCon solar cell in this embodiment of the present application includes operation S901 to operation S905.

Operation S901: Perform double-sided texturing on an N-type monocrystalline silicon wafer, to obtain a silicon substrate 901 provided with second texture structures 9012. For example, alkaline texturing may be performed using, for example, a 3 wt% sodium hydroxide solution, so that the second texture structures 9012 are pyramid structures, and are separately distributed on a first surface 901a and a second surface 901b of the silicon substrate 901 that are opposite to each other.

Operation S902: Dope the second surface 901b of the silicon substrate 901 provided with the second texture structures 9012 using a diffusion process, to form an emitter 907, as shown in (b) of FIG. 9. For example, the emitter 907 may be formed in the second surface 901b of the silicon substrate using a boron diffusion process.

Operation S903: Perform single-sided polishing on the first surface 901a of the silicon substrate 901 that is opposite to the second surface 901b, to obtain the first surface 901a provided with a plurality of first texture structures 9011, as shown in (c) of FIG. 9. In a direction away from the first surface 901a, each of the first texture structures 9011 includes a bottom surface 9011c, a side surface 9011b, and a top surface 9011a. The top surface 9011a is connected to one end of the side surface 9011b, and the bottom surface 9011c is connected to the other end of the side surface 9011b.

Operation S904: Sequentially form a tunneling layer 902, a doped semiconductor layer 903, a first passivation anti-reflection layer 906, and an electrode material on the first surface 901a of the silicon substrate 901, and sequentially form a second passivation anti-reflection layer 908 and an electrode material on a surface of the emitter 907. For example, the doped semiconductor layer 903 is an N-type doped polycrystalline silicon layer formed using a phosphorus diffusion process.

Operation S905: Sinter the electrode material to form an electrode 904, make the electrode 904 located on the first surface 901a in contact with the doped semiconductor layer 903 through the first passivation anti-reflection layer 906, and form metal crystals 905 at a position in the doped semiconductor layer 903 that is in contact with the electrode 904; and make the electrode 904 located on the second surface 901b in contact with the emitter through the second passivation anti-reflection layer 908, as shown in (d) of FIG. 9. The sintering operation of the electrode 904 located on the first surface 901a specifically includes: undersintering the electrode material using a thermal process; and then irradiating an edge region of the undersintered electrode material that is in contact with the doped semiconductor layer 903 with a laser.

In the foregoing exemplary embodiment of the present application, in the single-sided polishing in operation S903, chain-type equipment is used, and the single-sided polishing is performed using a polishing agent containing 68 wt% of HNO₃ and 0.2 wt% of HF, and a cross-section of an eventually manufactured TOPCon solar cell has a morphology shown in FIG. 3 and FIG. 6A to FIG. 6C. Distribution densities of metal crystals in the doped polycrystalline silicon layers located on the top surface and the bottom surface are greater than a distribution density of metal crystals in the doped polycrystalline silicon layer located on the side surface.

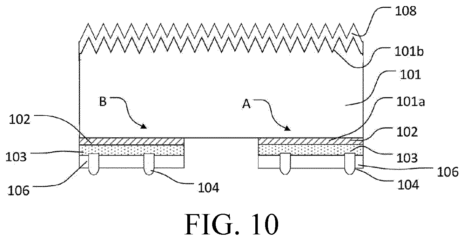

According to embodiments of another aspect of the present application, a back contact solar cell including the foregoing distribution structure of metal crystals is further provided. FIG. 10 is a schematic diagram of a structure of a back contact solar cell according to still another embodiment of the present application. Differences from the structure of the solar cell shown in FIG. 1 mainly lie in that the first surface is a back surface of the back contact solar cell, the first surface 101a includes a first region A and a second region B that are alternately distributed at intervals, and the foregoing tunnel passivated contact structure formed by the tunneling layer 102 and the doped semiconductor layer 103 is located on the first region A or separately located on the first region A and the second region B. In this case, the distribution structure of metal crystals in the doped semiconductor layer 103 is the same as that described above, and details are not described herein again.

For example, as shown in FIG. 10, in an embodiment, the tunnel passivated contact structure may be separately located on the first region A and the second region B. In this case, the tunneling layer 102 and the doped semiconductor layer 103 may be understood as a patterned layer structure, and a corresponding back contact solar cell is a TOPCon-Back Contact (TBC) solar cell. In addition, the doped semiconductor layer 103 located on the first region A and the doped semiconductor layer 103 located on the second region B have different doping types. For example, the doped semiconductor layer 103 located on the first region A is N-type doping and the doped semiconductor layer 103 located on the second region B is P-type doping, or the doped semiconductor layer 103 located on the first region A is P-type doping, and the doped semiconductor layer 103 located on the second region B is N-type doping.

For example, in another embodiment, the tunnel passivated contact structure located on the second region B may be replaced with another passivated contact structure. For example, the tunneling layer 102 and the doped semiconductor layer 103 that are located on the second region B are entirely replaced with an aluminum back field, to form an aluminum back field passivated structure on the second region B. A corresponding back contact solar cell may be a hybrid passivated back contact (HPBC) solar cell. Alternatively, for another example, the tunneling layer 102 and the doped semiconductor layer 103 that are located on the second region B are entirely replaced with intrinsic amorphous silicon and doped amorphous silicon that are sequentially disposed in a direction away from the second region, to form a heterojunction passivated contact structure on the second region B. A corresponding back contact solar cell may be a hybrid back contact (BC) solar cell.

According to the embodiments of the present application, the distribution structure of metal crystals of the present application may be relatively widely applicable to various solar cell types including a tunnel passivated contact structure, to reduce a burn-through risk at a side surface of the first texture structures and optimize a current collection path, thereby improving the efficiency of the solar cell.

## Claims

1. A solar cell, comprising:
a semiconductor substrate, comprising a first surface provided with a plurality of first texture structures, wherein each of the first texture structures comprises a side surface and a top surface in a direction away from the first surface, and the top surface is connected to one end of the side surface;
a tunneling layer, located on the first surface of the semiconductor substrate;
a doped semiconductor layer, located on a surface of the tunneling layer away from the semiconductor substrate;
an electrode, located on a surface of the doped semiconductor layer away from the semiconductor substrate, and in contact with the doped semiconductor layer; and
metal crystals, wherein a distribution density of the metal crystals in the doped semiconductor layer located on the top surface is greater than a distribution density of the metal crystals in the doped semiconductor layer located on the side surface.

2. The solar cell according to claim 1, wherein the first texture structure is a protrusion structure, and a ratio of a lateral dimension of an orthographic projection of the side surface on a plane in which the top surface is located to a lateral dimension of the top surface ranges from 0.1 to 0.3.

3. The solar cell according to claim 2, wherein the lateral dimension of the orthographic projection of the side surface on the plane in which the top surface is located ranges from 0.3 to 3 µm, and the lateral dimension of the top surface ranges from 5 to 25 µm.

4. The solar cell according to claim 1 or 2, wherein the first texture structure further comprises a bottom surface, connected to the other end of the side surface away from the top surface, and located between the side surfaces of two adjacent first texture structures; and
a distribution density of the metal crystals in the doped semiconductor layer located on the bottom surface is greater than the distribution density of the metal crystals in the doped semiconductor layer located on the side surface.

5. The solar cell according to claim 3, wherein a distance between two adjacent first texture structures is less than or equal to 9 µm; and a height from the bottom surface to the top surface ranges from 0.1 to 0.8 µm.

6. The solar cell according to any one of claims 1 to 3 and 5, wherein the side surface has a curvature recessed toward an interior of the semiconductor substrate.

7. The solar cell according to claim 1, wherein the metal crystals are dendritic, tooth-like, or flower-like nanoparticles; and
a particle size of the metal crystals ranges from 20 to 200 nm.

8. The solar cell according to claim 1 or 7, wherein the metal crystals are an alloy containing a metal element of the electrode and a silicon element.

9. The solar cell according to claim 1, wherein the semiconductor substrate further comprises a second surface provided with a plurality of second texture structures, and each of the second texture structures is a concave structure or a protrusion structure; and
the solar cell further comprises an emitter, formed in the second surface of the semiconductor substrate.

10. A manufacturing method for the solar cell, comprising:
texturing and polishing a first surface of an initial substrate to form a plurality of first texture structures on the first surface to obtain a semiconductor substrate;
sequentially manufacturing a tunneling layer, a doped semiconductor layer, a first passivation anti-reflection layer, and an electrode material on the first surface of the semiconductor substrate; and
sintering the electrode material to form an electrode, making the electrode in contact with the doped semiconductor layer through the first passivation anti-reflection layer, and forming metal crystals at a position in the doped semiconductor layer that is in contact with the electrode, wherein a distribution density of the metal crystals in the doped semiconductor layer located on the top surface is greater than a distribution density of the metal crystals in the doped semiconductor layer located on the side surface.

11. The method according to claim 10, wherein the solar cell is a solar cell according to any one of claims 1 to 9.
